# EUROPÄISCHE PATENTSCHRIFT

(11) **EP 1 388 940 B1**
(45) Veröffentlichungstag und Bekanntmachung des Hinweises auf die Patenterteilung: **30.05.2012**
(21) Anmeldenummer: 03011569.5
(22) Anmeldetag: 22.05.2003
(51) Int. Cl.: H03K 17/0412, H03K 17/04, H03K 17/0812

(54) **Schaltungsanordnung zur Ansteuerung von Leistungstransistoren**
Circuit arrangement for controlling power transistors
Montage servant à commander des transistors de puissance

(30) Priorität: 09.08.2002 DE 10236532
(43) Veröffentlichungstag der Anmeldung: 11.02.2004
(73) Patentinhaber: SEMIKRON Elektronik GmbH & Co. KG, 90431 Nürnberg (DE)
(72) Erfinder: Do Nascimento, Jair, 91077 Dormitz (DE)

(56) Entgegenhaltungen:
- EP-A- 0 487 964
- WO-A-98/12816
- US-A- 4 877 982

## Beschreibung

Die Erfindung beschreibt eine Schaltungsanordnung zur Ansteuerung des Gates eines Leistungshalbleitertransistors, wie z.B. eines MOS-FETs oder eines IGBTs. Derartige Leistungshalbleitertransistoren finden vielfältigen Einsatz als Leistungsschalter in verschiedensten Anwendungsgebieten der Technik wie beispielhaft der Ansteuerung von Elektromotoren.

Leistungstransistoren nach dem Stand der Technik, wie IGBTs oder MOS-FETs sind Ausgangspunkt dieser Erfindung. Derartige Leistungstransistoren, beispielhaft IGBTs werden angesteuert, d.h. in einen leitenden oder nicht leitenden Zustand geschaltet, indem zwischen Gate und Emitter eine bestimmte Spannung angelegt wird. Um den Transistor in einen leitenden Zustand, d.h. Stromfluss zwischen Kollektor und Emitter, zu schalten wird hierzu das Gate mit der angelegten Spannung geladen. In den nicht leitenden Zustand wird der Transistor geschaltet, indem das Gate umgeladen, d.h. mit Ladungen der jeweils anderen Polarität geladen wird. Dies erfolgt beispielhaft bei IGBTs indem eine Spannung entgegengesetzter Polarität zwischen Gate und Emitter angelegt wird. Diese Umschaltvorgänge werden auch als Kommutierung bezeichnet. Die gleichen Zusammenhänge, wie oben für einen IGBT beschrieben, gelten in der weiteren Beschreibung auch für die entsprechenden Anschlüsse Drain und Source eines MOS-FET Bauelements, wobei allerdings meist ein MOS-FET in den nicht leitenden Zustand geschaltet wird, indem eine Spannung von 0V angelegt wird.

Es sind verschiedene Prinzipien der Ansteuerung von Leistungstransistoren bekannt. Dies sind die Gateansteuerung mittels Widerstandsansteuerung, mittels Spannungsansteuerung sowie mittels Stromansteuerung. Am weitesten verbreitet hiervon ist die Widerstandsansteuerung. Charakteristisch für eine derartige Ansteuerung ist die Ausbildung eines sog. Millerplateaus im zeitlichen Verlauf der Spannung zwischen Gate und Emitter während eines Umschalt- (Kommutierungs-) vorgangs. Die Versorgung des Gates im zeitlichen Verlauf nach dem Durchlaufen des Millerplateaus zeigt den Verlauf einer Kurve mit einer (1-exp(-t)) Abhängigkeit.

Nachteilig an den Gateansteuerungen mittels Widerstandsansteuerung bzw. Spannungsansteuerung ist die Notwendigkeit einer stabilisierten Versorgungsspannungsquelle. Diese ist unumgänglich um die Durchlassverluste des Leistungstransistors, der eine definierte Gatespannung benötigt, gering zu halten.Ebenfalls nachteilig am zeitlichen Verlauf der Ladekurve des Gates nach dem Millerplateau ist, dass hierdurch der Schaltvorgang des Leistungstransistors verzögert wird. Der Leistungstransistor schaltet nicht mit der Geschwindigkeit, zu der er technologisch fähig wäre. Folge dieses verzögerten Schaltens sind Schaltverluste. Ebenfalls durch o.g. Zeitverhalten begründet kann eine Überwachung der Kollektor- Emitter- Spannung, die nach dem Stand der Technik während des Schaltvorganges selbst nicht wirksam ist, erst mit einer durch dieses Zeitverhalten bedingten Verzögerung aktiviert werden.

Aus der US 4,877,982 ist eine stromgeregelte Schaltungsanordnung zur Ansteuerung von mindestens einem Leistungshalbleitertransistor bestehend aus zwei geregelten Stromquellen mit einer gemeinsamen Spannungsversorgung und einer Ausgangsspannungsregelung gekannt, wobei die erste Stromquelle den Transistor leitend und die zweite Stromquelle den Transistor nicht leitend schaltet.

Die vorliegende Erfindung hat die Aufgabe, eine Schaltungsanordnung zur Ansteuerung von Leistungshalbleitertransistoren vorzustellen, die bei einem geringen schaltungstechnischen Aufwand eine gleichmäßige und schnelle Ladung bzw. Um- oder Entladung des Gates des Leistungstransistors zur Verfügung stellt um damit die Schaltverluste bei der Kommutierung gering zu halten sowie die Kommutierung sanft zu gestalten.

Die Aufgabe wird gelöst durch die Maßnahmen des Anspruchs 1. Weitere vorteilhafte Ausgestaltungen sind in den Unteransprüchen genannt.

Der Grundgedanke der Erfindung wird anhand eines n-Kanal IGBTs als anzusteuernder Leistungstransistor beschrieben. Selbstverständlich gilt dies in entsprechend angepasster Weise für p-Kanal IGBTs sowie alle weiteren in gleicher Weise anzusteuernden Leistungstransistoren wie z.B. MOS-FETs. Der Grundgedanke beruht auf einer stromgeregelten Versorgung des Gates des Leistungstransistors, d.h. geregelt wird hier der Ladestrom des Gates, nicht die Ladespannung. Hierzu weist die erfinderische Schaltungsanordnung mehrere Schaltungsteile auf.

In der Betrachtung sind weiterhin zwei alternierend vorhandene Betriebsweisen zu unterscheiden, der stationäre Zustand und der Kommutierungsvorgang. Als stationärer Zustand wird die Zeit verstanden, während der sich der Ladezustand des Gates nicht ändert, d.h. also während der der Leistungstransistor im leitenden oder nicht leitenden Zustand verbleibt. Als Kommutierungsvorgang wird das Umschalten des Leistungstransistors vom nicht leitenden in den leitenden Zustand oder umgekehrt bezeichnet, hierbei wird der Ladezustand des Gates verändert.

Ein beispielhafter erster Teil einer Schaltungsanordnung zur Ansteuerung des Gates eines Leistungstransistors ist eine Eingangsbeschaltung, diese begrenzt den Eingangsstrom der Schaltungsanordnung. Der Eingangsstrom weist einen zeitvariablen binären Spannungsverlauf auf. Der HIGH- bzw. LOW- Zustand bestimmt den Leitungszustand des Leistungstransistors. Die Eingangsbeschaltung ist vorteilhafterweise derart ausgeführt, dass im stationären Zustand ein Widerstand die Stromaufnahme der folgenden Schaltungsteile begrenzt. Während des Kommutierungsvorgangs kann ein größerer Strom diese Eingangsbeschaltung durchfließen.

Erfindungsgemäß wird das Gate des Leistungstransistors mittels der Ausgänge zweier geregelter Stromquellen versorgt. Das Eingangssignal der beiden Stromquellen ist das Ausgangssignal der Eingangsbeschaltung. Gespeist werden die Stromquellen jeweils aus einer Spannungsquelle. Die erste Stromquelle wird aus einer ungeregelten Spannungsquelle mit positiver Polarität versorgt und stellt die positive Spannung für die Ansteuerung des Gates des Leistungstransistors zur Verfügung. Die zweite Stromquelle wird aus einer ungeregelten Spannungsquelle negativer Polarität versorgt und stellt die negative Spannung für die Ansteuerung des Gates des Leistungstransistors zur Verfügung. Beide Spannungsquelllen sind in ihrem internen Aufbau spiegelsymmetrisch.

Das Ausgangssignal der beiden Stromquellen wird mittels einer Spannungsregelung auf einen geeigneten Maximalwert für den jeweiligen Leistungstransistor begrenzt. Erfindungsgemäß wirkt diese Spannungsregelung zurück auf die Eingänge der Stromquellen um bei einer zu hohen Spannung die Nachspeisung aus den Stromquellen zu verringern.

Vorteilhaft ist , wenn die Schaltungsanordnung noch einen weiteren Schaltungsteil aufweist, der bei vollständig inaktiver Ansteuerung eine Aufladung des Gates und damit einen undefinierten Schaltzustand des Leistungstransistors verhindert.

Die genannte erfinderische Schaltungsanordnung weist gegenüber dem Stand der Technik eine Mehrzahl von Vorteilen auf:
- Der Kommutierungsvorgang hat einen geringeren Zeitbedarf. Dadurch wird
   - die Verlustleistung in den Leistungstransistoren reduziert und
   - die Kurzschlussüberwachung kann frühzeitiger aktiviert werden.
- Es sind keine geregelten Spannungsversorgungen notwendig. Dadurch wird
   - die notwendige Kapazität der Siebkondensatoren verringert.
- Der gesamte Schaltungsaufwand wird geringer.

Spezielle Ausgestaltungen der erfinderischen Lösungen werden an Hand der Fig. 1 bis 3 erläutert.
- Fig. 1: zeigt eine Ausgestaltung der erfinderischen Schaltungsanordnung.
- Fig. 2: zeigt in einer Simulation den zeitlichen Verlauf der Gate- Emitter- Spannung bei Widerstandsansteuerung nach dem Stand der Technik während eines Kommutierungsvorgangs.
- Fig. 3: zeigt in einer Simulation den zeitlichen Verlauf der Gate- Emitter- Spannung bei erfinderischer Stromansteuerung während eines Kommutierungsvorgangs.

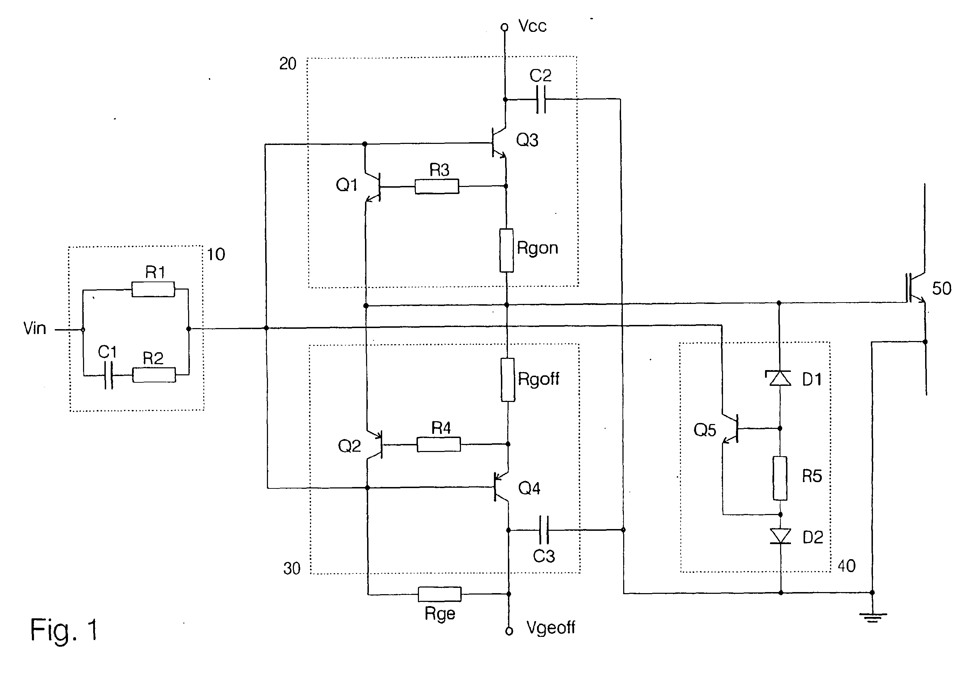

Fig. 1 zeigt eine Ausgestaltung der erfinderischen Schaltungsanordnung zur Ansteuerung eines n- Kanal IGBTs (50). Zur Dimensionierung der Schaltung sei auf folgende Tabelle verwiesen:

| | |
|---|---|
| R1 | 1,2kΩ |
| R2 | 100Ω |
| R3 | 100Ω |
| R4 | 100Ω |
| R5 | 100Ω |
| Rgon | 0,27Ω |
| Rgoff | 0,56 |
| Rge | 12kΩ |
| C1 | 22nF |
| C2 | 2µF |
| C3 | 4,7µF |

Eingangseitig wird die Schaltungsanordnung versorgt durch eine zeitvariable Spannung mit binären Zuständen. Der HIGH- (+5 V) bzw. LOW- (-5V) Zustand steuert den Leitungszustand des IGBTs (50). Hierzu sind eine Eingangsbeschaltung (10), zwei Stromquellen (20, 30) und eine Ausgangsspannungsregelung (40) vorgesehen.

Die Eingangsbeschaltung (10) besteht aus einem Widerstand (R1) und dazu parallel geschaltet einer Reihenschaltung aus einem Kondensator (C1) und einem Widerstand (R2). Das nach dieser Eingangsbeschaltung anstehende Signal ist mit den Eingängen der beiden geregelten Stromquellen (20, 30) verbunden.

Die geregelte Stromquelle (20) besteht aus einer Schaltungsanordung zweier npn-Transistoren (Q1, Q3). Versorgt wird die Spannungsquelle aus der ungeregelten Versorgungsspannung (Vcc), welche eine Spannung +18V...+24V aufweist. Der Kondensator (C2) dient als Siebkondensator. Die geregelte Stromquelle (30) ist spiegelsymmetrisch zur Stromquelle (20) aufgebaut, wobei hier zwei pnp- Transistoren (Q2, Q4) eingesetzt werden. Versorgt wird die Stromquelle aus der ungeregelten Versorgungsspannung (Vgeoff), welche eine Spannung -8V aufweist. Der Kondensator (C3) dient als Siebkondensator.

Weiterhin weist die Schaltungsanordnung eine Spannungsbegrenzung (40) bestehend aus einer Zenerdiode (D1), einem Widerstand (R5) einer Diode (D2) sowie einem Transistor (Q5) auf. Der Kollektor des Transistors (Q5) ist hierbei mit den Eingängen der Stromquellen (20, 30) verbunden.

Weiterhin weist die Schaltungsanordnung noch einen Widerstand (Rge) auf, der bei vollständig inaktiver Ansteuerung eine Aufladung des Gates und damit einen undefinierten Schaltzustand des Leistungstransistors verhindert.

Im weiteren wird die Funktion der Schaltungsanordnung sowie die Aufgaben der einzelnen Schaltungsteile in den verschiedenen Betriebszuständen beschrieben. Für den stationären Zustand bei anliegendem HIGH- Pegel als Spannung (Vin) gilt: Die Eingangsbeschaltung (10) beschränkt mittels des Widerstandes (R1) den Strom, der als Steuerstrom auf die Eingänge der Stromquellen (20, 30) geschaltet ist. Somit begrenzt dieser Widerstand (R1) die Basisströme der Transistoren (Q3, Q4). Da es sich beim Transistor (Q4) der Stromquelle (30) um einen pnp- Transistor handelt, ist dieser in diesem Zustand nicht angesteuert und somit die gesamte Stromquelle (30) inaktiv.

Der Eingangsstrom liegt ebenfalls an der Basis des npn- Transistors (Q3) und begrenzt somit den im stationären Zustand maximal durch diesen Transistor fließenden Strom zum IGBT (50). Die Stromquelle (20) versorgt somit das Gate des IGBTs (50) mit einer positiven Steuerspannung und hält den IGBT damit in dem leitenden Zustand.

Die Spannungsbegrenzung (40) detektiert einen möglichen Spannungsanstieg der Spannung zwischen Gate und Emitter des IGBT (50) oberhalb des Sollwerts von +15V. Hierzu ist die Reihenschaltung aus der Zenerdiode (D1), dem Widerstand (R5) und der Diode (D2) derart ausgelegt, dass ein Strom durch diesen Zweig fließt, sobald eine Spannung größer als +15V anliegt. Somit wird die Gate- Emitter- Spannung des IGBTs auf +15V geregelt. Weiterhin steuert der in diesem Zweig fließende Strom den Transistor (Q5), womit der Basisstrom am Transistor (Q3) der Stromquelle (20) reduziert wird und somit auch der durch diesen Transistor zum Gate des IGBT (50) fließende Strom. Innerhalb der Spannungsbegrenzung (40) verhindert der Widerstand (R5), dass der Transistor (Q5) durch einen Leckstrom durch die Zenerdiode (D1) leitend wird. Die Diode (D2) sorgt dafür, dass im ausgeschalteten Zustand dieser Zweig und somit die Spannungsbegrenzung (40) nicht wirksam ist.

Für den stationären Zustand bei anliegendem LOW- Pegel als Spannung (Vin) gilt: Die Eingangsbeschaltung (10) beschränkt ebenfalls mittels des Widerstandes (R1) den Strom, der als Steuerstrom auf die Eingänge der Stromquellen (20, 30) geschaltet ist. Da es sich beim Transistor (Q3) der Stromquelle (20) um einen npn- Transistor handelt, ist dieser in diesem Zustand nicht angesteuert und somit die gesamte Stromquelle (20) inaktiv.

Der Eingangsstrom liegt ebenfalls an der Basis des pnp- Transistors (Q4) und begrenzt somit den im stationären Zustand maximal durch diesen Transistor fließenden Strom zum IGBT (50). Die Stromquelle (30) versorgt somit das Gate des IGBTs (50) mit einer negativen Steuerspannung und hält den IGBT damit in dem nicht leitenden Zustand.

Eine Spannungsbegrenzung ist in diesem Fall nicht aktiv, da eine ungeregelete Gatespannung von ca. -8V ausreichend ist um den IGBT stabil im nicht leitenden Zustand gehalten.

Während des Kommutierungsvorgangs wechselt der Pegel der Eingangsspannung (Vin) der Schaltungsanordnung von HIGH- auf LOW- Pegel oder von LOW- auf HIGH- Pegel, d.h. der IGBT (50) muss seinen Schaltzustand ändern. Hierzu ist es geeignet, wenn ein höherer Strom durch die Eingangsbeschaltung fließt und damit ein höherer Strom aus einer der beiden Stromquellen (20, 30) zum Gate des IGBT (50). Der höhere Stromdurchlass der Eingangsschaltung (10) wird mittels des parallel geschalteten Zweiges aus dem Kondensator (C1) und dem Widerstand (R2) erreicht, da während der Pegeländerung durch diesen Zweig ebenfalls ein Strom fließt.

Bei der Kommutierung von LOW nach HIGH erzeugt die Stromquelle (20) einen positiven Strom zum Gate des IGBT (50), der Widerstand (Rgon) fungiert hier als Shuntwiderstand, wobei bei einem zu hohen Strom durch den Transistor (Q3) ein Teil dieses Stromes auf die Basis des Transistors (Q1) geleitet wird. Dieser wird leitend und reduziert dadurch den Basisstrom zum Transistor (Q3), was eine Reduzierung des Stromes durch diesen bewirkt. Der Kondensator (C2) wirkt als Siebkondensator für die Spannungsquelle (Vcc). Somit ist eine geregelte Stromquelle geschaffen, die die Basis des IGBTs (50) auflädt. Die Spannungsregelung (40) arbeitet wie im stationären Zustand bereits beschrieben.

Bei der Kommutierung von HIGH nach LOW erzeugt die Stromquelle (30) in analoger Weise einen negativen Strom zum Gate des IGBT (50).

Um zu gewährleisten, dass auch in Betriebszuständen ohne Eingangsspannung (Vin) der IGBT (50) sich sicher im nicht leitenden Zustand befindet, wird nach dem Stand der Technik ein Widerstand zwischen Gate und Emitter des IGBTs (50) angeordnet. Die erfinderische Anordnung dieses Widerstandes Rge zwischen der negativen Spannungsquelle (Vgeoff) und der Basis des Transistors (Q4) erweist sich demgegenüber als vorteilhaft. Durch diese Anordnung wird der Widerstandswert von Rge durch den Stromverstärkungsfaktor des Transistors (Q4) dividiert, d.h. der effektiv wirkende Wert ist mindestens um den Faktor 100 kleiner als beim jetzigen Stand der Technik und das Gate ist sehr niederohmig über den Widerstand (Rgoff) an den Emitter angebunden.

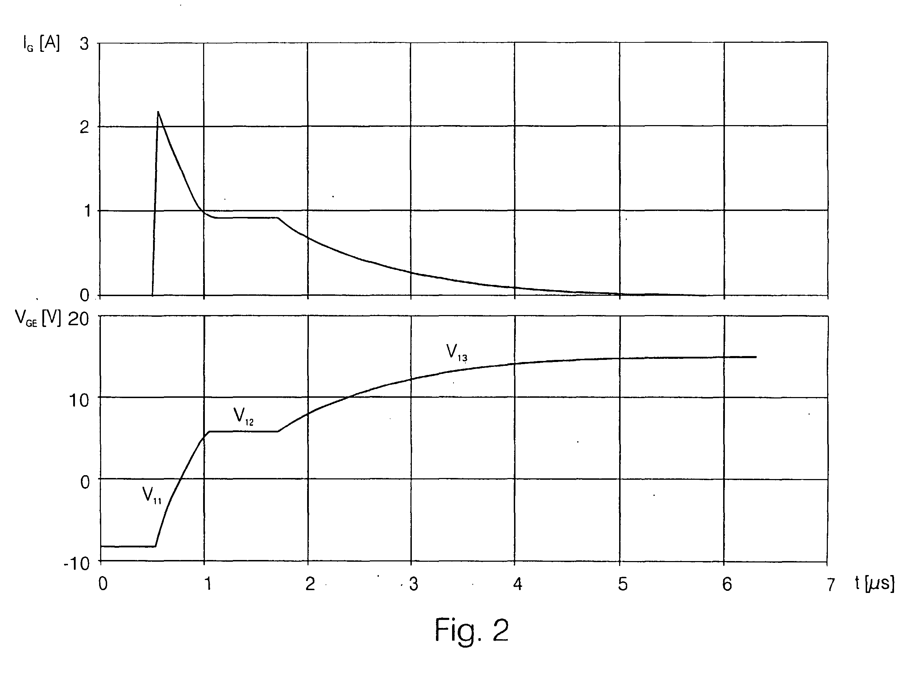

Fig. 2 zeigt in einer Simulation den zeitlichen Verlauf sowohl der Gate- Emitter- Spannung V_{GE} als auch des Ladestromes I_{G} des Gates bei Widerstandsansteuerung nach dem Stand der Technik während eines Kommutierungsvorgangs. Zu Beginn des Kommutierungsvorgangs bei 0,5µs steigt der Ladestrom I_{G} stark an, während die Spannung V_{GE} annährend linear steigt (V₁₁). Nach ca. 0,5µs ist das Millerplateau (V₁₂) erreicht, dessen zeitliche Ausdehnung ca. 0,7µs beträgt. In dieser Zeit ist auch der Ladestrom I_{G} konstant. Im weiteren zeitlichen Verlauf (V₁₃) steigt die Gate- Emitter- Spannung bis zum Erreichen des gewünschten Wertes mit einer (1-exp(-t)) Charakteristik. Der gewünschte Wert von 15V wird nach ca. 6µs erreicht. In dieser Zeit sinkt der Ladestrom I_{G} ebenfalls in charakteristischer Weise.

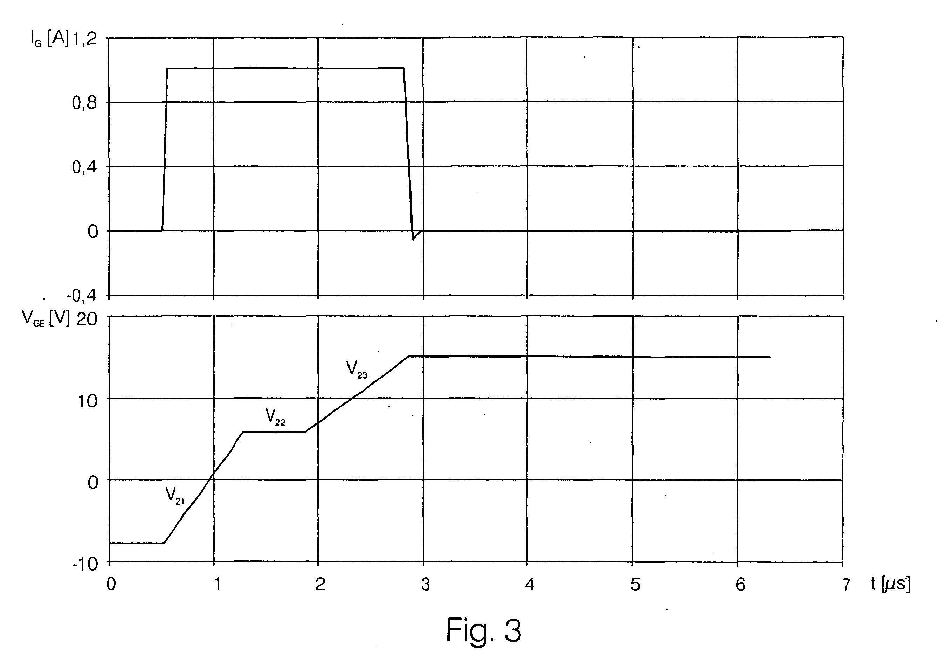

Fig. 3 zeigt in einer Simulation den zeitlichen Verlauf sowohl der Gate- Emitter- Spannung V_{GE} als auch des Ladestromes I_{G} des Gates bei erfinderischer Stromansteuerung während eines Kommutierungsvorgangs. Charakteristisch für die erfinderische Stromansteuerung ist der hierbei konstante Ladestrom I_{G}. Während des Ladevorgangs steigt die Spannung V_{GE} linear (V₂₁) bis zum Erreichen des Millerplateaus (V₂₂). Anschließend steigt die Spannung wiederum linear (V₂₃) bis zum Erreichen des gewünschten Sollwertes von 15V.

Im Vergleich mit den korrespondierenden Kurven nach dem Stand der Technik (Fig. 2) ist zu erkennen, das die erfinderischen Schaltungsanordnung das Gate in etwa der halben Zeit (ca. 3µs) auf den gewünschten Wert lädt. Hierbei ist vor allem der durch die Schaltungsanordnung ermöglichte lineare Verlauf (V₂₃) der Gate- Emitter- Spannung nach dem Millerplateau (V₂₂) vorteilhaft und ermöglicht somit schnellere Schaltvorgänge des Leistungstransistors.

## Patentansprüche

1. Stromgeregelte Schaltungsanordnung zur Ansteuerung von mindestens einem Leistungshalbleitertransistor (50) bestehend aus dem Leistungshalbleitertransistor mit Gate, Emitter und Kollektor oder mit Gate, Source und Drain und aus zwei geregelten Stromquellen (20, 30), deren Ausgänge miteinander und mit dem Gate verbunden sind, und deren Eingänge mit einem Ausgang einer Eingangsbeschaltung (10) verbunden sind, und einer Ausgangsspannungsregelung (40), wobei die erste geregelte Stromquelle (20) aus einer ersten ungeregelten Spannungsquelle (Vcc) gespeist wird und das Gate des Leistungstransistors (50) derart ansteuert, dass der Leistungstransistor leitend ist, wobei die zweite geregelte Stromquelle (30) spiegelsymmetrisch zu der ersten geregelten Stromquelle (20) aufgebaut ist, wobei die zweite geregelte Stromquelle (30) aus einer zweiten ungeregelten Spannungsquelle (Vgeoff) gespeist wird und das Gate des Leistungstransistors (50) derart ansteuert, dass der Leistungstransistor nicht leitend ist, und die Ausgangsspannungsregelung (40) die auf den Emitter oder die Source des Leistungshalbleitertransistor (50) bezogene Spannung am Gate des Leistungshalbleitertransistors (50) auf einen vom Leistungshalbleitertransistor abhängigen Maximalwert begrenzt, **dadurch gekennzeichnet, dass** die Ausgangsspannungsregelung (40) direkt auf die Eingänge der geregelten Stromquellen (20, 30) rückwirkt, dass die erste geregelte Stromquelle (20) ausgebildet ist als eine Schaltung zweier npn- oder zweier n-Kanal- Transistoren (Q1, Q3), und dass die zweite geregelte Stromquelle (30) ausgebildet ist als eine Schaltung zweier pnp- oder zweier p-Kanal- Transistoren (Q2, Q4).

2. Schaltungsanordnung nach Anspruch 1, wobei der Schaltungsanordnung eine einen Eingangsstrom begrenzende Eingangsbeschaltung (10) vorgeschaltet ist.

3. Schaltungsanordnung nach Anspruch 1, wobei der Leistungshalbleitertransistor ein MOS-FET ist und die Spannung der zweiten ungeregelten Spannungsquelle (Vgeoff) 0V beträgt.

## Claims

1. A current-regulated circuit arrangement for controlling at least one power semiconductor transistor (50) consisting of the power semiconductor transistor with gate, emitter and collector or with gate, source and drain and of two regulated current sources (20, 30), the outputs of which are connected to one another and to the gate and the inputs of which are connected to an output of an input circuit (10), and an output voltage regulation (40), wherein the first regulated current source (20) is supplied from a first non-regulated voltage source (Vcc) and controls the gate of the power transistor (50) in such a manner that the power transistor is conductive, wherein the second regulated current source (30) is structured mirror-symmetrically to the first regulated current source (20), wherein the second regulated current source (30) is supplied from a second non-regulated voltage source (Vgeoff) and controls the gate of the power transistor (50) in such a manner that the power transistor is non-conductive, and the output voltage regulation (40) limits the voltage drawn to the emitter or the source of the power semiconductor transistor (50) at the gate of the power semiconductor transistor (50) to a maximum value dependent on the power semiconductor transistor, **characterised in that** the output voltage regulation (40) in turn acts directly on the inputs of the regulated current sources (20, 30), **in that** the first regulated current source (20) is constructed as a circuit of two npn- or two n-channel transistors (Q1, Q3) and **in that** the second regulated current source (30) is constructed as a circuit of two pnp- or two p-channel transistors (Q2, Q4).

2. The circuit arrangement according to Claim 1, wherein an input circuit (10) limiting an input current is connected upstream of the circuit arrangement.

3. The circuit arrangement according to Claim 1, wherein the power semiconductor transistor is a MOS-FET and the voltage of the second non-regulated voltage source (Vgeoff) is 0V.

## Revendications

1. Agencement de circuit régulé au niveau du courant pour l'actionnement d'au moins un transistor à semi-conducteurs de puissance (50) constitué du transistor à semi-conducteurs de puissance avec porte, émetteur et collecteur ou avec porte, source et drain et de deux sources de courant (20, 30) régulées, sources dont les sorties sont reliées les unes aux autres et à la porte, et dont les entrées sont reliées à une sortie d'un câblage d'entrée (10), et d'un dispositif de réglage de tension de sortie (40), la première source de courant (20) régulée étant alimentée à partir d'une première source de tension (Vcc) non régulée et actionnant la porte du transistor de puissance (50), de telle sorte que le transistor de puissance est conducteur, la seconde source de courant (30) régulée étant établie avec une symétrie spéculaire par rapport à la première source de courant régulée (20), la seconde source de courant (30) régulée étant alimentée à partir d'une seconde source de tension (Vgeoff) non régulée et actionnant la porte du transistor de puissance (50), de telle sorte que le transistor de puissance n'est pas conducteur, et le dispositif de réglage de tension de sortie (40) limite la tension rapportée à l'émetteur ou à la source du transistor à semi-conducteurs de puissance (50) sur la porte du transistor à semi-conducteurs de puissance (50) à une valeur maximale dépendante du transistor à semi-conducteurs de puissance, **caractérisé en ce que** le dispositif de réglage de la tension de sortie (40) réagit directement sur les entrées des sources de courant (20, 30) régulées, **en ce que** la première source de courant (20) régulée est conçue sous forme d'un circuit de deux transistors à canal NPN ou de deux transistors à canal N (Q1, Q3), et **en ce que** la seconde source de courant (30) régulée est conçue sous forme d'un circuit de deux transistors à canal PNP ou de deux transistors à canal P (Q2, Q4).

2. Agencement de circuit selon la revendication 1, dans lequel un câblage d'entrée (10) limitant un courant d'entrée est placé en amont de l'agencement de circuit.

3. Agencement de circuit selon la revendication 1, dans lequel le transistor à semi-conducteurs de puissance est un MOS-FET et la tension de la seconde source de tension non régulée (Vgeoff) est égale à 0 V.
